# EUROPÄISCHE PATENTSCHRIFT

(11) **EP 0 784 338 B1**
(45) Veröffentlichungstag und Bekanntmachung des Hinweises auf die Patenterteilung: **21.11.2001**
(21) Anmeldenummer: 97100388.4
(22) Anmeldetag: 11.01.1997
(51) Int. Cl.: H01L 21/3063, C25F 3/12

(54) **Verfahren zum Herstellen von nebeneinanderliegenden Gräben oder Löchern**
Process for manufacturing trenches or holes side by side
Procédé pour la fabrication de tranchées ou perforations côte à côte

(30) Priorität: 11.01.1996 DE 19600782
(43) Veröffentlichungstag der Anmeldung: 16.07.1997
(73) Patentinhaber: Micronas GmbH, 79108 Freiburg (DE)
(72) Erfinder: Igel, Günter, Dipl.-Ing., 79312 Emmendingen (DE)

(56) Entgegenhaltungen:
- EP-A- 0 296 348
- EP-A- 0 528 281
- FR-A- 1 284 532
- US-A- 5 229 682
- PROCEEDINGS OF THE WORKSHOP ON MICRO ELECTRO MECHANICAL SYSTEMS INVESTIGATION OF MICRO STRUCTURES, SENSORS, ACTUATORS, MACHINES AND ROBOTS, NARA, JP., JAN. 30 - FEB. 2, 1991, Nr. WORKSHOP 4, 30.Januar 1991, INSTITUTE OF ELECTRICAL AND ELECTRONICS ENGINEERS, Seiten 221-226, XP000295572 BRANEBJERG J: "DOPANT SELECTIVE HF ANODIC ETCHING OF SILICON FOR THE REALIZATION OF LOW-DOPED MONOCRYSTALLINE SILICON MICROSTRUCTURES"

## Beschreibung

Die Erfindung betrifft ein Verfahren zum Herstellen von nebeneinanderliegenden Gräben oder Löchern in einem Halbleitersubstrat bei dem eine elektrisch isolierende Maskierungsschicht auf das Substrat aufgebracht wird.

Ein solches Verfahren ist aus der EP 0 296 348 bekannt. Dort werden nebeneinanderliegende Gräben oder Löcher in einem Siliziumsubstrat durch elektrolythische Ätzung erzeugt. Solche Löcher oder Gräben im Silizium werden in der Mikroelektronik und der Leistungsbauelemente-Elektronik verwendet. Ferner sind aus der Praxis chemische Ätzverfahren und Plasmaätzverfahren zur Erzeugung von loch- oder grabenförmigen Strukturen bekannt.

Der Nachteil der bekannten Verfahren besteht darin, daß es bei kleinen Strukturen schwierig ist, zwei Gräben oder Löcher dicht nebeneinander zu erzeugen. Der Abstand der Gräben oder Löcher wird durch die Photolithographietechnik begrenzt, mit der die entsprechenden Öffnungen in der Maskierungsschicht ausgebildet werden müssen. So ist es mit der heutigen Technologie problematisch, in Halbleitersubstraten nebeneinanderliegende Gräben oder Löcher herzustellen, deren Abstand 5 µm oder weniger betragen soll.

Der Erfindung liegt die Aufgabe zugrunde, ein Verfahren zum Herstellen von nebeneinanderliegenden Gräben oder Löchern in einem elektrisch nichtisolierenden Substrat zu schaffen, mit dem es möglich ist, zwei dicht nebeneinanderliegende Gräben zu schaffen.

Diese Aufgabe wird durch ein Verfahren gemäß dem Oberbegriff des Patentanspruchs 1 gelöst, bei dem die Maskierungsschicht zur Ausbildung jeweils zweier nebeneinanderliegender Gräben oder Löcher eine Öffnung aufweist, deren Breite so bestimmt ist, daß sie sich über einen Teil der Gesamtbreite der beiden auszubildenden Gräben oder Löcher erstreckt, und daß der Verlauf der Öffnung senkrecht zu deren Breite dem Verlauf der auszubildenden Gräben oder Löcher senkrecht zur Breite entspricht, und daß dann an der Oberfläche des maskierten Substrats eine anodische Oxidation durchgeführt wird, wobei die Oxidationsspannung so hoch gewählt wird, daß pro Öffnung in der Maske zwei nebeneinanderliegende Gräber oder Löcher entstehen.

Das erfindungsgemäße Verfahren hat den Vorteil, daß zur Erzeugung zweier nebeneinanderliegender Gräben oder Löcher nur eine Öffnung in der Maskierungsschicht vorgesehen werden muß. Wenn die Oxidationsspannung zur Durchführung der anodischen Oxidation genügend hoch gewählt wird, bilden sich während des Oxidationsprozesses unterhalb der Öffnung in der Maskierungsschicht zwei nebeneinanderliegende Gräben oder Löcher aus. Dieser überraschende Effekt wurde in Versuchen beobachtet. Er scheint daher zu kommen, daß aufgrund der hohen Spannung die während des Oxidationsprozesses erzeugte Oxidschicht durchbrochen wird. Während der Oxidationsprozeß weitergeht, entstehen dabei die beiden nebeneinanderliegenden Kanäle oder Löcher. Ihre Form wird dabei durch den Verlauf der Feldlinien des elektrischen Feldes aufgrund der Oxidationsspannung bestimmt. Die Ausbildung der Kanäle oder Löcher beginnt am Rand der Öffnung in der Maskierungsschicht, wo die Feldstärke am größten ist. Der Abstand der beiden Kanäle oder Löcher wird durch die Breite der Öffnung in der Maskierungsschicht bestimmt. Bei einer breiteren Öffnung ist der Abstand zwischen den beiden Gräben oder Löchern größer. Welchen Verlauf die Löcher oder Gräben in der Richtung senkrecht zur Breite der Öffnung annehmen, wird durch den Verlauf der Öffnung in der zu der Breite senkrechten Richtung bestimmt. So werden beispielsweise durch eine Öffnung in der Form eines langen Rechtecks zwei parallel zueinander verlaufende gerade Kanäle erzeugt. Der Verlauf der Kanäle wird durch den Verlauf der Öffnung bestimmt. Zudem können mit dem erfindungsgemäßen Verfahren nebeneinanderliegenden Gräben oder Löcher mit einem kleinen Abstand voneinander hergestellt werden, da für zwei nebeneinander liegende Gräben oder Löcher nur eine Maskenöffnung erforderlich ist und sich daher die Begrenzung der Breite der Öffnung aufgrund des fotolitografischen Herstellungsverfahrens auf zwei nebeneinanderliegende Gräben verteilt.

Bevorzugterweise ist die Spannungsfestigkeit der Maskierungsschicht hinsichtlich der Oxidationsspannung so gewählt, daß eine Oxidation unterhalb der Maskierungsschicht verhindert wird. Die Spannungsfestigkeit wird durch die Dicke und das Material der Maskierungsschicht bestimmt. Günstigerweise ist die Oxidationsspannung wenigstens eine Größenordnung höher als bei einer üblichen anodischen Oxidation. In dieser Größenordnung wurden die besten Ergebnisse erzielt. Bei Halbleitern beträgt die Oxidationsspannung bei einer üblichen anodischen Oxidation zwischen etwa 1 bis 10 V und bei dem erfindungsgemäßen Verfahren etwa 100 V oder mehr.

Günstigerweise wird die Oxidationszeit der anodischen Oxidation so bestimmt, daß eine vorgegebene Tiefe der nebeneinanderliegenden Gräben erzeugt wird. Die Abhängigkeit der Tiefe von der Oxidationszeit kann für eine vorgegebene Breite und einen vorgegebenen Verlauf der Maskenöffnung in Vorversuchen bestimmt werden. Durch Festlegen der Oxidationszeit wird dann in zuverlässiger Weise eine vorgegebene Form und Tiefe der Gräben oder Löcher erzielt.

Gemäß einem bevorzugten Ausführungsbeispiel der Erfindung wird die Breite der Öffnung der Maskierungsschicht so klein gewählt, daß zwischen zwei Gräben ein spitzenförmiger Trennwall entsteht. In einem Siliziumsubstrat kann dies beispielsweise mit einer Maskierungsschicht, bei der die Breite der Öffnung etwa 7 µm beträgt, erzielt werden. Auf diese Weise kann zwischen den Kanälen eine Siliziumspitze erzeugt werden. Abhängig von der Anwendung einer solchen Siliziumspitze kann gegebenenfalls die Oxidschicht von einem bestimmten Bereich der Spitze wieder entfernt werden; auch kann die Siliziumspitze durch Aufbringen einer Metallschicht metallisiert werden. Mögliche Anwendungen eines solchen spitzenförmigen Trennwalls sind beispielsweise Kathoden für Miniröhren, die kalte Elektronen emittieren kann, Spitzen von Tunnelmikroskopen, und ähnliches. Soll die Spitze metallisiert werden, so kann dies beispielsweise durch gerichtetes Sputtern erreicht werden. Da die mit dem erfindungsgemäßen Verfahren erzeugten Gräben einen Querschnitt haben, der erheblich gößer ist als die Breite der Öffnung der Maske, erstrecken sie sich auch in einen Bereich unterhalb der Maskierungsschicht. Infolgedessen kann die Breite der Öffnung als Abschirmung beim Aufbringen des Metalls verwendet werden, so daß nur der Bereich um den spitzenförmigen Trennwall metallisiert wird und in dem übrigen Bereich eine Isolierschicht erhalten bleibt.

Bevorzugterweise kann die Oxidationszeit so gewählt werden, daß der Trennwall zwichen zwei Gräben hinsichtlich der Substratoberfläche abgesenkt wird. Die Oxidationszeit muß hier so lange verlängert werden, bis zwischen der Spitze des Trennwalls und der Substratoberfläche ein vorgegebener Abstand erreicht worden ist. Dies ist dann wünschenswert, wenn die Siliziumspitze als eine Kathode zur Elektronenemission verwendet wird. Dann kann die Anode oberhalb der Öffnung auf der Substratoberfläche bzw. der Maskierungsschicht angebracht werden. Der Abstand der Kathode zu der Öffnung in dem überstehenden Substrat bzw. der Maskierungsschicht kann dann so eingestellt werden, daß die Elektronen geeignet in die Anode fokusiert werden können.

Gemäß einem weiteren Ausführungsbeispiel der Erfindung kann auf die Wände der Gräben oder Löcher eine Metallschicht aufgebracht werden. Dies ist z.B. dann vorteilhaft, wenn die Gräben zur Kühlung verwendet werden sollen. Da das Metall eine gute Wärmeleitfähigkeit hat, kann die Fläche der Gräben besser zum Abführen der Wärme benutzt werden. Auch kann eine Schicht aufgebracht werden, mit der die Wände der Gräben oder Löcher verspiegelt werden. Dies ist insbesondere dann vorteilhaft, wenn in die Gräben Lichtleiter eingebracht werden sollen, da dann eine bessere Lichtleitung erzielt wird.

Gemäß einem bevorzugten Ausführungsbeispiel der Erfindung werden die Gräben mit einer Verschlußschicht auf der Substratoberfläche verschlossen. So können geschlossene Gräben mit einem einfachen Verfahren hergestellt werden. Da die Breite der Öffnung der Gräben an der Substratoberfläche klein ist, d.h. deutlich kleiner als der Querschnitt der Gräben, ist ein zuverlässiges Schließen der Gräben auf diese Weise sehr einfach möglich. Mit der Verschlußschicht werden die Gräben zur Substratoberfläche hin zuverlässig abgeschlossen. Somit kann beispielsweise eine Kühlflüssigkeit durch die Gräben geleitet werden, wobei sichergestellt ist, daß sie nicht aus den Gräben austreten kann. Mit dem erfindungsgemäßen Verfahren ist es möglich zwei Gräben nebeneinander anzuordnen, wobei die Gräben an einem Ende miteinander verbunden werden können und somit als Hin- und Rückführung für eine Kühlflüssigkeit verwendet werden können. Hierzu genügt es im Prinzip zwei nebeneinanderliegende Gräben auszubilden. Es können aber auch mehrere oder eine Vielzahl von nebeneinanderliegenden Gräben ausgebildet werden, wodurch bei der Verwendung zur Kühlung die Kühlwirkung erhöht wird. Es ist auch möglich solche Gräben auszubilden, bei denen die Verschlußschicht wieder durchbrochen wird, so daß eine die Gräben durchfließende Flüssigkeit in zu der Flußrichtung senkrechter Richtung durch die Oberfläche des Substrats austreten kann. Eine mögliche Anwendung wäre hierbei etwa ein Tintenstrahldrucker. Die Verschlußschicht kann vorteilhafter Weise auf das maskierte Substrat aufgebracht werden, so daß keine zusätzlichen Verfahrensschritte nötig sind.

Auch kann die Substratoberfläche nach der anodischen Oxidation einer thermischen Oxidation unterzogen werden, bei der die Gräben an der Substratoberfläche ganz oder teilweise geschlossen werden. Durch die Bildung von SiO₂ werden die Hohlräume in den Gräben und damit auch die Öffnung an der Substratoberfläche kleiner, wobei letztere auch ganz geschlossen werden können. Ob zusätzlich eine Verschlußschicht auf die Substratoberfläche aufgebracht wird, und wie weit die Öffnungen an der Substratoberfläche durch Oxidation geschlossen werden, ist vom Fachmann für den jeweiligen Anwendungsfall zu entscheiden.

Im folgenden wird die Erfindung anhand der Figur näher erläutert.

Es zeigen:
Fig. 1 zwei in einem Substrat nebeneinander liegende, gemäß dem erfindungsgemäßen Verfahren hergestellte, zur Substratoberfläche hin verschlossene Gräben,
Fig. 2 zwei in einem Substrat nebeneinander liegende, gemäß dem erfindungsgemäßen Verfahren hergestellte Gräben, bei denen eine Maskierungsschicht mit einer schmaleren Öffnung als in der Fig. 1 verwendet wurde und
Fig. 3 eine gemäß dem erfindungsgemäßen Verfahren hergestellte Anordnung, die eine Elektronen emittierende Kathode aufweist.

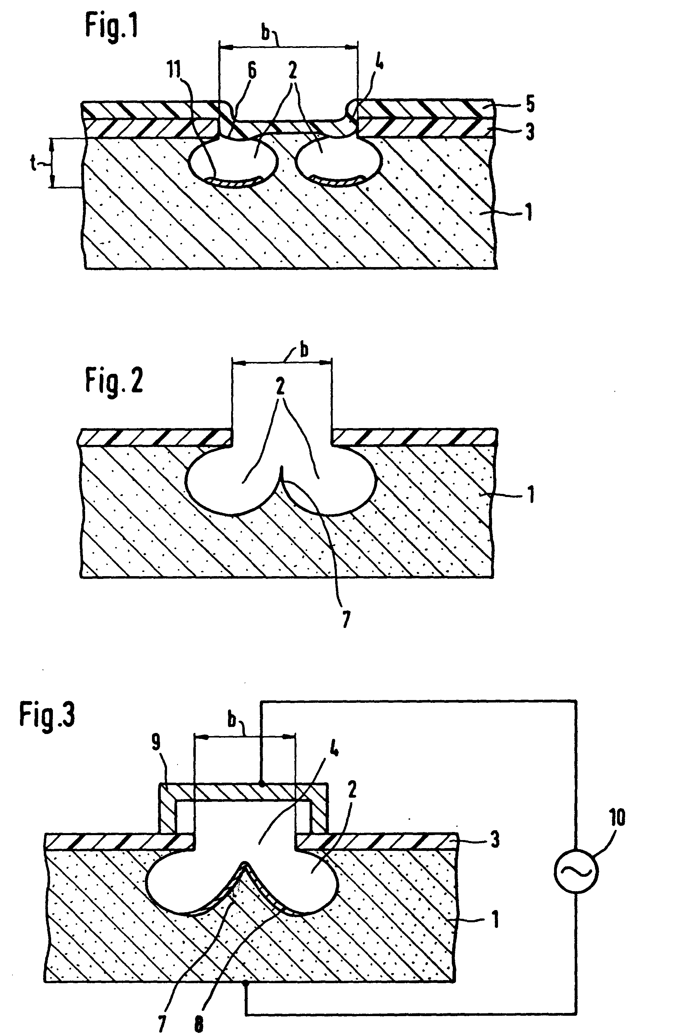

Fig. 1 zeigt ein Querschnitt durch einen Teil eines Substrats 1, in dem zwei nebeneinander liegende Gräben 2 ausgebildet sind. Auf dem Substrat ist eine Maskierungsschicht 3 aufgebracht. Die Maskierungsschicht 3 weist eine Öffnung 4 einer Breite b auf. Die Gräben 2, die sich in dem Substrat 1 aufgrund einer anodischen Oxidation, die an dem maskierten Substrat 1 durchgeführt wurde, ausgebildet haben, erstrecken sich in dem Substrat 1 unterhalb der Öffnung 4 der Maskierungsschicht 3 und zu einem erheblichen Teil auch unterhalb der Maskierungsschicht 3. Man entnimmt der Figur, daß sich unterhalb der Öffnung 4 der Maskierungsschicht 3 zwei nebeneinanderliegende Gräben 2 ausbilden. Der Querschnitt dieser Gräben gibt in etwa den Feldlinienverlauf des elektrischen Feldes bei der Durchführung einer anodischen Oxidation wieder. Wenn in dem gezeigten Beispiel das Substrat aus Silizium besteht, kann die gezeigte Konfiguration mit einer Maskierungsschicht erreicht werden, deren Öffnung und Breite zwischen 10 bis 15 µm aufweist.

Die Dicke der Maskierungsschicht 3 ist dabei so festgelegt, daß sie unter Berücksichtigung ihres Materials eine Spannungsfestigkeit hinsichtlich der Oxidationsspannung zur Durchführung der anodischen Oxidation aufweist, bei der die Maskierungsschicht 3 während der Oxidation erhalten bleibt und ihre Dicke sich nicht ändert. Die Tiefe t der Gräben 2 wird durch die Oxidationszeit bestimmt. Bei einer gewünschten Tiefe t der Gräben 2 wird die Oxidation beendet. Eine Verschlußschicht 5, die auf das maskierte Substrat 1 mit den Gräben 2 aufgebracht ist, verschließt die Öffnungen der Gräben 2 der Oberfläche des Substrats 1. Da die Grabenöffnungen 6 klein im Vergleich zum Querschnitt der Gräben 2 sind, lassen sich die Grabenöffnungen 6 mit der Verschlußschicht 5 leicht verschließen. Auf der unteren Seite der Gräben 2 ist unterhalb der Grabenöffnung 6 eine Schicht 11 ausgebildet, die beim Aufbringen der Verschlußschicht 5 entsteht. Im gezeigten Beispiel wurde sie durch einen gerichteten, räumlich anisotropen Prozeß, beispielsweise durch Sputtern aufgebracht. Bei einem ungerichteten Prozeß zum Aufbringen der Verschlußschicht 5, beispielsweise durch Bedampfen, können auch die Wände der Gräben 2 vollständig mit einer entsprechenden Schicht bedeckt werden. Material und Art des Aufbringens können abhängig vom Anwendungsfall gewählt werden.

Fig. 2 zeigt einen Querschnitt durch ein Substrat 1, das ebenfalls zwei nebeneinander liegende Gräben 2 aufweist. Die auf dem Substrat 1 vorgesehene Maskierungsschicht 3 weist eine Öffnung 4 auf, deren Breite kleiner ist als die der Fig. 1. Die Gräben 2 sind ebenfalls durch anodische Oxidation unter gleichen Bedingungen, abgesehen von der Breite b der Öffnung 4 der Maskierungsschicht 3, wie in Fig. 1 hergestellt. Aufgrund der kleineren Breite b der Öffnung 4 entsteht zwischen den beiden Gräben 2 ein spitzenförmiger Trennwall 7. Durch eine entsprechend lange Oxidationszeit ist der Trennwall 7 hinsichtlich der Substratoberfläche abgesenkt.

Fig. 3 zeigt ebenfalls eine gemäß dem erfindungsgemäßen Verfahren hergestellte Anordnung. Die Ausbildung der Gräben 2 ist unter den gleichen Bedingungen erfolgt wie in Fig. 2. Es wurde zusätzlich eine Metallschicht 8 auf den spitzenförmigen Trennwall 7 aufgebracht. Die Maskierung zum Aufbringen der Metallschicht 8 erfolgte durch die Maskierungsschicht 3. Somit ist die Spitze des Trennwalls 7 metallisiert und die übrigen Wände der Gräben 2 isolieren die Metallschicht 8 von der Oberfläche des Substrats 1. In diesem Ausführungsbeispiel dient der metallisierte Trennwall 7 als Kathode, aus der Elektronen emittiert werden können. Oberhalb der Öffnung 4 in der Maskierungsschicht 3 ist eine Anode 9 aus Metall angeordnet. Durch Anlegen einer geeigneten Spannung an die Metallschicht 8 und die Anode 9 mittels einer Spannungsquelle 10 können die aus der Metallschicht 8 austretenden Elektronen durch die Anode 9 geeignet beschleunigt und fokussiert werden.

Im folgenden wird das erfindungsgemäße Verfahren am Ausführungsbeispiel der Fig. 1 beschrieben. Auf ein Substrat 1 wird eine Maskierungsschicht 3 aufgebracht, in der, üblicherweise durch Photolithographie, eine Öffnung 4 der Breite b erzeugt wird. Dann wird an dem maskierten Substrat 1 eine anodische Oxidation durchgeführt. Hierzu wird üblicherweise auf das maskierte Substrat 1 eine leitfähige, Sauerstoff enthaltende Flüssigkeit aufgebracht. Die Flüssigkeit kann, wenn das Substrat ein Halbleiterwafer ist, beispielsweise in einem um den Wafer gelegten Dichtungsring gehalten werden. Die Oxidationsspannung wird an das Substrat 1 und an eine in die Flüssigkeit eingetauchte Elektrode angelegt. Die anodische Oxidation wird für eine vorgegebene Zeit durchgeführt. Während dieser Oxidation entstehen die nebeneinanderliegenden Gräben 2. Die Oxidation wird dann beendet, wenn die Gräben 2 eine vorgegebene Tiefe t erreicht haben. Nach Beenden der Oxidation und Entfernen der Oxidationsflüssigkeit wird auf die Oberfläche des maskierten Substrats 1 eine Verschlußschicht 5 aufgebracht. Mit der Verschlußschicht 5 werden die Grabenöffnungen 6 bedeckt, so daß die Gräben 2 gegen die Oberfläche des Substrats abgeschlossen sind. Ferner entsteht dabei die Schicht 11. Die Oxidationsspannung ist wenigstens eine Größenordnung höher als bei einer üblichen anodischen Oxidation. Wenn das Substrat 1 ein Halbleitersubstrat ist, wird die anodische Oxidation mit einer Oxidationsspannung vor mindestens 100 V durchgeführt.

## Patentansprüche

1. Verfahren zum Herstellen von nebeneinanderliegenden Gräben (2) oder Löchern *in einem Halbleitersubstrat* (1) bei dem eine elektrisch isolierende Maskierungsschicht (3) auf das Substrat (1) aufgebracht wird, wobei die Maskierungsschicht (3) zur Ausbildung jeweils zweier nebeneinanderliegender Gräben (2) oder Löcher eine Öffnung (4) aufweist, und wobei dann an der Oberfläche des maskierten Substrats (1) eine anodische Oxidation durchgeführt wird, **dadurch gekennzeichnet, daß** die Oxidationsspannung so hoch gewählt wird, daß pro Öffnung in der Maskierungsschicht (3) zwei nebeneinanderliegende Gräben (2) oder Löcher entstehen und daß sich die Gräben (2) oder Löcher seitlich unter die Maskierungsschicht (3) über den Rand der Öffnung (4) hinaus erstrecken und daß die Gräben (2) oder Löcher entlang dem Rand der Öffnung verlaufen.

2. Verfahren nach Anspruch 1, **dadurch gekennzeichnet, daß** die Spannungsfestigkeit der Maskierungschicht (3) hinsichtlich der Oxidationsspannung so gewählt ist, daß eine Oxidation unterhalb der Maskierungsschicht verhindert wird.

3. Verfahren nach einem der vorangehenden Ansprüche, daß die Oxidationsspannung wenigstens eine Größenordnung höher ist als bei einer üblichen anodischen Oxidation.

4. Verfahren nach einem der vorangehenden Ansprüche, **dadurch gekennzeichnet, daß** die anodische Oxidation mit einer Oxidationsspannung von mindestens 100 V durchgeführt wird.

5. Verfahren nach einem der vorangehenden Ansprüche, **dadurch gekennzeichnet, daß** die Oxidationszeit der anodischen Oxidation so bestimmt wird, daß eine vorgegebene Tiefe (t) der nebeneinanderliegenden Gräben (2) erzeugt wird.

6. Verfahren nach einem der vorangehenden Ansprüche, **dadurch gekennzeichnet, daß** die Breite (b) der *Öffnung der* Maskierungsschicht (3) so klein gewählt wird, daß zwischen zwei Gräben (2) ein spitzenförmiger Trennwall entsteht.

7. Verfahren nach einem der vorangehenden Ansprüche, **dadurch gekennzeichnet, daß** die Oxidationszeit so gewählt wird, daß der Trennwall (7) *zwischen zwei Gräben* (2) hinsichtlich der Substratoberfläche abgesenkt wird.

8. Verfahren nach einem der vorangehenden Ansprüche, **dadurch gekennzeichnet, daß** auf die Wände der Gräben (2) oder Löcher eine Metallschicht (8) aufgebracht wird.

9. Verfahren nach einem der vorangehenden Ansprüche, **dadurch gekennzeichnet, daß** die Gräben (2) mit einer Verschlußschicht (5) auf der Substratoberfläche verschlossen werden.

10. Verfahren nach Anspruch 9, **dadurch gekennzeichnet, daß** die Verschlußschicht (5) auf das maskierte Substrat (1) aufgebracht wird.

11. Verfahren nach einem der vorangehenden Ansprüche, **dadurch gekennzeichnet, daß** die Substratoberfläche nach der anodischen Oxidation einer thermischen Oxidation unterzogen wird, bei der die Gräben an der Substratoberfläche ganz oder teilweise geschlossen werden.

## Claims

1. A process for forming adjacent moats (2) or holes in a semiconductor substrate (1) wherein an electrically insulating masking layer (3) is deposited on the substrate (1), the masking layer (3) having respective openings (4) for forming pairs of adjacent moats (2) or holes, and wherein an anodic oxidation is then carried out at the surface of the masked substrate (1), **characterized in that** the oxidation voltage is chosen to be so high that two adjacent moats (2) or holes are formed per opening in the masking layer (3) and that the moats (2) or holes extend laterally below the masking layer (3) and beyond the edge of the openingl (4) and that the moats (2) or holes extend along the edge of the opening.

2. A process as claimed in claim 1, **characterized in that** the dielectric strength of the masking layer (3) with respect to the oxidation voltage is chosen so that oxidation below the masking layer is prevented.

3. A process as claimed in either of the preceding claims, **characterized in that** the oxidation voltage is at least one order of magnitude higher than during conventional anodic oxidation.

4. A process as claimed in any one of the preceding claims, **characterized in that** the anodic oxidation is carried out with an oxidation voltage of at least 100 V.

5. A process as claimed in any one of the preceding claims, **characterized in that** the oxidation time of the anodic oxidation is chosen so that a predetermined depth (t) of the adjacent moats (2) is obtained.

6. A process as claimed in any one of the preceding claims, **characterized in that** the width (b) of the opening in the masking layer (3) is chosen to be so small that a spike-shaped dividing wall is formed between two moats (2).

7. A process as claimed in any one of the preceding claims, **characterized in that** the oxidation time is chosen so that the dividing wall (7) between two moats (2) is lowered below the level of the substrate surface.

8. A process as claimed in any one of the preceding claims, **characterized in that** a metal layer (8) is applied to the walls of the moats (2) or holes.

9. A process as claimed in any one of the preceding claims, **characterized in that** the moats (2) are closed with a capping layer (5) on the substrate surface.

10. A process as claimed in claim 9, **characterized in that** the capping layer (5) is deposited on the masked substrate (1).

11. A process as claimed in any one of the preceding claims, **characterized in that** after the anodic oxidation, the substrate surface is subjected to a thermal oxidation whereby the moats are closed; wholly or in part, at the substrate surface.

## Revendications

1. Procédé pour la réalisation de tranchées (2) ou de perforations disposées côte à côte dans un substrat de semiconducteur (1), dans lequel on dépose une couche de masquage électriquement isolante (3) sur le substrat (1), dans lequel la couche de masquage isolante (3) comporte, à chaque fois, pour la réalisation de deux tranchées (2) ou perforations disposées côte à côte, une ouverture (4) et dans lequel on réalise ensuite, sur la surface du substrat (1) muni du masque, une oxydation anodique, **caractérisé en ce que** l'on choisit une tension d'oxydation dont la valeur est élevée de telle manière que, pour chaque ouverture, on crée, dans la couche de masquage isolante (3), deux tranchées (2) ou perforations disposées côte à côte et que les tranchées (2) ou perforations se développent, en sortant, sur le côté, sous la couche de masquage isolante (3), au dessus du bord de l'ouverture (4) et **en ce que** les tranchées (2) ou perforations s'étendent le long du bord de l'ouverture (4).

2. Procédé selon la revendication 1, **caractérisé en ce que** la rigidité diélectrique de la couche de masquage isolante (3) vis-à-vis de la tension d'oxydation est choisie de telle manière que l'on empêche une oxydation en dessous de la couche de masquage isolante (3).

3. Procédé selon l'une quelconque des revendications précédentes, **caractérisé en ce que** la tension d'oxydation est supérieure d'au moins un ordre de grandeur au cas de l'oxydation anodique usuelle.

4. Procédé selon l'une quelconque des revendications précédentes, **caractérisé en ce que** l'oxydation anodique est réalisée avec une tension d'oxydation d'au moins 100 V.

5. Procédé selon l'une quelconque des revendications précédentes, **caractérisé en ce que** la durée de l'oxydation de l'oxydation anodique est déterminée de telle manière que l'on produise une profondeur prédéterminée (t) des tranchées (2) disposées côte à côte.

6. Procédé selon l'une quelconque des revendications précédentes, **caractérisé en ce que** la largeur (b) de *l'ouverture* de la couche de masquage isolante (3) est choisie avec une valeur tellement faible qu'il se crée une paroi de séparation de forme pointue (7) entre deux tranchées (2).

7. Procédé selon la revendication 6, **caractérisé en ce que** la durée de l'oxydation est choisie de telle manière que la paroi de séparation (7) *disposée entre deux tranchées (2)* est abaissée par rapport à la surface du substrat.

8. Procédé selon l'une quelconque des revendications précédentes, **caractérisé en ce que** l'on dépose une couche de métal (8) sur les parois des tranchées (2) ou perforations.

9. Procédé selon l'une quelconque des revendications précédentes, **caractérisé en ce que** les tranchées (2) sont refermées au moyen d'une couche de fermeture (5) sur la surface du substrat.

10. Procédé selon la revendication 9, **caractérisé en ce que** la couche de fermeture (5) est déposée sur le substrat (1) muni du masque.

11. Procédé selon l'une quelconque des revendications précédentes, **caractérisé en ce que**, après l'oxydation anodique, on soumet la surface du substrat à une oxydation thermique au cours de laquelle les tranchées (2) sont entièrement ou partiellement fermées au niveau de la surface du substrat.
